# DEMANDE DE BREVET EUROPEEN

(11) **EP 0 757 388 A1**
(43) Date de publication de la demande: **05.02.1997**
(21) Numéro de dépôt: 96401484.9
(22) Date de dépôt: 05.07.1996
(51) Int. Cl.: H01L 27/01, H01G 2/10, H05K 1/16, H05K 3/28

(54) **Plaquette de circuit électronique en technologie couche épaisse**

(30) Priorité: 02.08.1995 FR 9509427
(71) Demandeur: SAT (Société Anonyme de Télécommunications), 75116 Paris (FR)
(72) Inventeur: Legeay, Gérard, 75625 Paris Cedex 13 (FR); Ferrand, Henri, 75625 Paris Cedex 13 (FR)
(74) Mandataire: Bloch, Gérard

(57) **Abrégé**

La plaquette comprend un condensateur (2, 3, 4) avec une couche (3) de pâte comme diélectrique, une couche (5) de protection de la couche diélectrique (3), à base de benzo-cyclo-butène.

L'invention permet de réaliser des circuits à fonctionnement très rapide.

## Description

La présente invention concerne une plaquette de circuit électronique en technologie couche épaisse, et plus particulièrement une telle plaquette comportant une condensateur en couche épaisse.

Une plaquette de circuit électronique en couche épaisse comporte des couches de pâte formant des éléments passifs, tels que résistances et condensateurs, ou des pistes de liaison, qui sont raccordés à des composants actifs rapportés, de diverses fonctions et technologies, l'ensemble constituant un module dit hybride.

Le module hybride présente l'intérêt de réunir les circuits actifs sur une faible surface. De ce fait, les liaisons entre ces circuits sont très courtes et n'apportent donc qu'un retard de transmission et un rayonnement limités. On utilise cette technologie lorsqu'on veut réaliser un ensemble électronique dont les divers circuits actifs ont un fonctionnement très rapide et échangent entre eux un grand nombre de signaux.

L'inconvénient présenté par les circuits rapides réside dans leur consommation élevée et dans l'apparition d'un pic de consommation lorsqu'ils changent d'état. De ce fait, la tension d'alimentation, dans le voisinage des circuits qui changent d'état, présente de brusques impulsions descendantes qui la font sortir de la plage spécifiée pour un bon fonctionnement de l'ensemble des circuits.

La source d'alimentation du module étant trop éloignée pour réagir en temps voulu, on répartit usuellement, sur toute la surface du module, des condensateurs réservoirs, dits de découplage. Ces condensateurs, chargés à la tension d'alimentation, fournissent localement quasi-instantanément aux circuits à consommation accrue un surcroît de courant, dès que la tension baisse, et limitent ainsi la perturbation, ce qui évite tout couplage perturbateur des divers circuits actifs à travers la distribution d'alimentation.

La demanderesse a alors cherché à réaliser ces condensateurs sous forme intégrée au module, c'est-à-dire en couches épaisses, afin d'éviter des opérations de report de condensateurs sous forme de composants discrets et, en particulier, en des endroits où seront montés les circuits actifs, pour assurer des liaisons courtes avec ceux-ci.

Il s'agissait donc de réaliser des condensateurs de découplage, de capacité suffisante pour fournir l'énergie voulue. Comme la capacité d'un condensateur est proportionnelle à la valeur de la constante diélectrique de la couche isolante séparant les deux plaques conductrices de celui-ci, il fallait donc trouver une pâte isolante à forte constante diélectrique. Or, les couches isolantes connues présentaient une constante diélectrique trop limitée.

La demanderesse a alors songé à utiliser un matériau à constante diélectrique élevée, mais poreux, incapable de conserver ses propriétés d'isolement dans des conditions climatiques défavorables. Ce matériau est connu dans la technologie couches minces mais il est considéré qu'il ne peut être utilisé tant que le problème de sa porosité n'aura pas été résolu (cf. l'ouvrage "Thin film, Multichip Modules" de G. Messner et autres, International Society for Hybrid Microelectronics, 1992, pages 195).

Divers essais de dépôt de couches de protection, connues pour la protection des couches épaisses, ont été effectués par la demanderesse sans succès. C'est alors qu'elle a eu l'idée de tester un produit à base de benzo-cyclo-butène. Ce produit, commercialisé sous la marque protégée Cyclotène 3022 par la société Dow Chemical, est connu, dans la technologie des couches minces, comme ayant des propriétés diélectriques et une absence d'absorption de l'eau.

En d'autres termes, pour constituer une couche de protection, la demanderesse a investigué un domaine autre que celui de la couche épaisse et considéré un produit connu pour sa bonne tenue diélectrique, c'est-à-dire apte à constituer l'isolant central d'un condensateur, ce qui n'a pas de rapport avec la fonction de protection recherchée.

Or, il s'est avéré, de façon surprenante, que ce produit avait aussi des propriétés de barrière contre les agressions climatiques et qu'il pouvait protéger la couche épaisse diélectrique.

L'invention concerne donc une plaquette de circuit électronique en technologie couche épaisse comprenant un condensateur avec une couche de pâte comme diélectrique, plaquette caractérisée par le fait qu'elle comporte une couche de protection de la couche diélectrique, à base de benzo-cyclo-butène.

On peut ainsi utiliser une pâte ayant les caractéristiques diélectriques recherchées, en la protégeant par une couche qui assure le maintien des caractéristiques d'isolement.

Avantageusement, la couche diélectrique est formée à partir d'un matériau poreux constitué du produit diélectrique de référence 4202 de la société E.S.L..

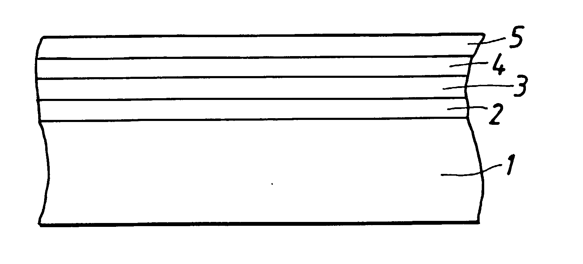

L'invention sera mieux comprise à l'aide de la description suivante d'une forme de réalisation préférée de la plaquette de l'invention, en référence à la figure unique du dessin qui en est une représentation fragmentaire latérale.

La plaquette de circuit électronique comporte une substrat isolant en alumine 1 sur lequel on été successivement appliquées, par sérigraphie, une couche 2 de pâte conductrice à base d'or, une couche diélectrique isolante 3, une couche 4 semblable à la couche 2 et une couche de protection 5.

La couche diélectrique 3 est formée à partir d'une pâte commercialisée par la société Electro Science Laboratory (E.S.L.), USA, sous la référence 4202 et présentant une valeur de constante diélectrique voisine de εᵣ = 2000.

La couche de protection 5 est formée à partir d'un vernis diélectrique de la marque protégée Cyclotène 3022 de la société Dow Chemical, qui est un produit à base de benzo-cyclo-butène (BCB). Ce produit est décrit dans le brevet EP-B-372 000 cité ici à titre de référence.

La couche diélectrique 3 et les deux couches 2 et 4 situées de part et d'autre constituent un condensateur protégé des agressions climatiques par la couche 5.

Des mesures comparatives d'isolement de la couche 3 ont été réalisées avec diverses autres couches de protection, à base de pâtes diélectriques ou de verre, commercialisées par la société ESL. Le tableau ci-après fournit les conditions d'essai et les résultats, pour une plaquette carrée de 5,08 cm de côté.

La couche 5 de BCB a été enduite à la tournette et polymérisée à 70 % directement sur l'électrode 4 en Or 8816, après étuvage de 2 heures à 300°C. L'isolement de 10⁴ MΩ relevé est de deux ordres de grandeur supérieur à celui procuré par les couches de comparaison et ne présente pas de dégradation perceptible après un mois de stockage à l'ambiante.

| **Couche de protection** | **Epaisseur diélectrique 4202** | **Résistance d'isolement** |
|---|---|---|
| **(5)** | **(3)** | **(couche 2/ couche 4)** |
| sans | 2 couches 32 µm | très faible |
| diélectrique 4913 | 2 couches 32 µm | 8-12 MΩ |
| diélectrique 4913 | 3 couches 50 µm | 20 MΩ |
| diélectrique 4040 | 2 couches 32 µm | 40 MΩ |
| diélectrique 4040 | 3 couches 50 µm | 60 MΩ |
| verre de scellement 4026-A | 2 couches 32 µm | 90 MΩ |
| diél. organique BCB 20 µm | 2 couches 32 µm | 10⁴ MΩ |

On comprendra que la couche 5 de l'invention peut être utilisée pour protéger d'autres couches de pâte sensible aux conditions climatiques, ayant ou non des propriétés diélectriques, utilisées pour réaliser tout type de composant.

## Revendications

1. Plaquette de circuit électronique en technologie couche épaisse comprenant un condensateur (2, 3, 4) avec une couche (3) de pâte comme diélectrique, plaquette caractérisée par le fait qu'elle comporte une couche (5) de protection de la couche diélectrique (3), à base de benzo-cyclo-butène.

2. Plaquette selon la revendication 1, dans laquelle la couche diélectrique (3) est formée à partir d'un matériau poreux.

3. Plaquette selon la revendication 2, dans laquelle le matériau poreux est constitué du produit diélectrique de référence 4202 de la société E.S.L..

4. Plaquette selon l'une des revendications 1 à 3, dans laquelle la couche de protection (5) est constituée du produit de la marque protégée Cyclotène.
